# FASCICULE DE BREVET EUROPEEN

(11) **EP 0 511 906 B1**
(45) Date de publication et mention de la délivrance du brevet: **24.05.1995**
(21) Numéro de dépôt: 92401199.2
(22) Date de dépôt: 27.04.1992
(51) Int. Cl.: G01R 29/24, G01R 29/14

(54) **Procédé et dispositif pour étudier les isolants électriques**
Verfahren und Gerät zum Untersuchen eines elektrischen Isolierungsmaterials
Procedure and apparatus for studying electrical insulators

(30) Priorité: 29.04.1991 FR 9105245
(43) Date de publication de la demande: 04.11.1992
(73) Titulaire: Lewiner, Jacques, 92210 Saint-Cloud (FR); Alquie, Claude neé Thibault, F-92340 Bourg-la-Reine (FR)
(72) Inventeur: Lewiner, Jacques, 92210 Saint-Cloud (FR); Alquie, Claude neé Thibault, F-92340 Bourg-la-Reine (FR)
(74) Mandataire: Behaghel, Pierre

(56) Documents cités:
- FR-A- 2 633 054
- REVUE GENERALE DE L'ELECTRICITE, no. 3, mars 1988, pages 37-43, Paris, FR; C.ALQUIE et al.: "La mesure des champs électriques dans les isolants pour câbleshaute tension: Perspectives ouvertes par la méthode de l'onde de pression"
- IEEE TRANSACTIONS ON NUCLEAR SCIENCE, vol. NS-29, no. 6, décembre 1982, pages1644-1649, New York, US; G.M. SESSLER et al.: "Nondestructive laser method formeasuring charge profiles in irradiated polymer films"

## Description

L'invention est relative aux procédés et dispositifs pour étudier les isolants électriques et plus particulièrement pour déterminer la distribution de certains paramètres électriques (charges, polarisations, champs...) à l'intérieur de ces isolants.

De telles études sont intéressantes en particulier pour connaître le comportement des isolants vis-à-vis de l'application sur eux de différences de potentiels électrique élevées, comme c'est le cas par exemple pour les gainages isolants des câbles destinés à transporter de l'énergie électrique sous une tension élevée, notamment de plusieurs de dizaines de kilovolts.

La connaissance du comportement des isolants en question permet en effet d'ajuster leurs épaisseurs et compositions en fonction des besoins et de leur apporter des corrections, éventuellement locales, susceptibles d'améliorer leurs performances et en particulier d'éviter leur claquage.

Selon un premier mode de réalisation connu (brevet FRANCE FR-A-2 633 054), on a proposé de placer un isolant entre deux électrodes entre lesquelles est appliquée une différence de potentiel continue, puis d'engendrer une déformation se propageant dans l'isolant d'une électrode à l'autre, la durée d'établissement t₀ de chaque déformation étant très inférieure à la durée t₁ de la traversée de l'isolant par cette déformation, puis d'amplifier les signaux électriques recueillis aux bornes des électrodes au cours de ladite traversée et d'enregistrer la suite de ces signaux aux fins d'exploitation.

Ces derniers sont des images de la distribution, dans l'isolant, des paramètres électriques (charges ou autres) présents localement dans cet isolant et susceptibles d'induire sur les électrodes des phénomènes électriques (charges ou autres).

Selon un second mode de réalisation connu (voir l'article de T. MAENO et al. paru aux pages 433 à 439 du n° 3 du volume 23, Juin 1988, de IEEE TRANSACTIONS ON ELECTRICAL INSULATION), on a proposé de placer encore un isolant entre deux électrodes entre lesquelles est appliquée une différence de potentiel continu, puis d'engendrer une déformation se propageant dans l'isolant à partir, cette fois-ci, des charges électriques présentes dans cet isolant, en appliquant entre les électrodes une impulsion de tension à temps de montée très bref : le champ électrique alors engendré brutalement dans l'isolant crée une pression sur lesdites charges, laquelle pression se propage vers les électrodes et peut être détectée au niveau de l'une au moins de celles-ci par un transducteur électromécanique approprié tel qu'un matériau piézoélectrique collé contre l'électrode considérée et placé lui-même entre deux électrodes auxiliaires.

Dans ce cas, le signal électrique (courant ou tension) apparaissant aux bornes du transducteur est une image de la distribution des charges ou autres à détecter.

Chacune de ces formules permet de connaître la distribution "électrique" en question au sein de l'isolant étudié, mais uniquement dans le cas où cette distribution est figée, la différence de potentiel appliquée sur l'isolant étant continue et donc invariable au cours de la mesure.

Or, il peut être intéressant pour certaines applications de suivre l'évolution de la distribution électrique considérée en fonction des variations d'une différence de potentiel appliquée aux bornes des électrodes, au cours même de ces variations.

En particulier, cette différence de potentiel peut être alternative, comme c'est le cas pour les isolants électriques constitutifs des gaines des câbles de transport de courant alternatif.

Il peut être précieux, par exemple, dans ce dernier cas, de connaître l'évolution de la distribution des charges électriques dans l'épaisseur de l'isolant à l'instant même de l'application sur cet isolant de ladite tension alternative, de façon à déterminer, en augmentant progressivement l'amplitude de cette tension, jusqu'à quel seuil de cette amplitude l'isolant étudié donne satisfaction.

L'invention a pour but surtout, de rendre possibles de telles études instantanées, c'est-à-dire effectuées au cours même de l'application de tensions alternatives aux bornes des électrodes entre lesquelles sont placés les isolants à étudier.

A cet effet on tire parti de la constatation suivante.

Si la fréquence de la tension alternative considérée est relativement basse et si l'épaisseur de la couche d'isolant à étudier est suffisamment faible, la durée t₁ de traversée de cet isolant par l'onde déformante ci-dessus évoquée demeure très petite par rapport à la période T de la tension alternative, ou plus précisément par rapport au quart T/4 de cette période, qui définit la variation d'amplitude correspondante.

C'est ainsi que, la vitesse de propagation de l'onde déformante dans les isolants habituels étant de l'ordre de 2000 m/s, si l'épaisseur de l'isolant à étudier est de 2 mm, la durée t₁ est de 1 »s, c'est-à-dire 5000 fois plus petite que le quart de période T/4 de la tension alternative si la fréquence de cette tension est de 50 Hz.

Par conséquent, on a grande latitude pour échantillonner la mesure en découpant le temps correspondant au quart de la période considérée en un certain nombre N de tranches de mesure séparées les unes des autres de temps tᵣ ou temps de récurrence.

Même avec une valeur raisonnable pour le nombre N, on peut donner à ce temps de récurrence tᵣ une valeur qui, comme il est nécessaire, est à la fois nettement supérieure à la durée t₁ de chaque mesure et nettement inférieure à T/4.

Dans l'exemple ci-dessus, ce temps tᵣ est avantageusement de l'ordre de la milliseconde, ce qui correspond à une valeur de N égale à 5.

Plus généralement, ledit temps tᵣ est compris entre 20 »s et 2 ms.

En d'autres termes, les procédés d'étude d'isolants électriques selon l'invention font encore appel, comme ceux définis ci-dessus, à la suite d'opérations suivantes : disposition de la masse isolante à étudier entre deux électrodes, application d'une différence de potentiel élevée aux bornes de ces électrodes, création dans l'isolant d'une déformation brusque se propageant à l'intérieur de cet isolant, amplification des signaux électriques engendrés par cette propagation, enregistrement de la suite S des signaux ainsi amplifiés et traitement des signaux enregistrés de façon à faire apparaître la distribution électrique dans l'isolant et ils sont essentiellement caractérisés en ce que l'on donne à la différence de potentiel une valeur variable, en ce que l'on renouvelle de façon récurrente la création de la déformation à une fréquence fᵣ comprise entre 500 et 50000 Hz, en ce que l'on enregistre successivement de multiples suites S de signaux correspondant respectivement aux propagations successives des déformations récurrentes dans l'isolant et en ce que l'on traite les suites S ainsi enregistrées de façon à faire apparaître la distribution électrique dans l'isolant.

Pour ce qui est des dispositifs d'étude selon l'invention, ils sont essentiellement caractérisés en ce qu'ils comprennent : un générateur de fonctions propre à engendrer une tension électrique variable dans le temps, un amplificateur propre à amplifier la tension issue du générateur de fonctions, la tension ainsi amplifiée étant appliquée aux bornes d'électrodes encadrant l'isolant, un dispositif propre à créer des déformations brusques se propageant à l'intérieur de l'isolant, un dispositif de retardement synchronisé avec le générateur de fonctions propre à déclencher le dispositif créateur de déformations d'une façon récurrente, à une fréquence fᵣ comprise entre 500 et 50000 Hz, des moyens pour enregistrer successivement de multiples suites S de signaux liés aux signaux électriques engendrés par les propagations successives des déformations récurrentes dans l'isolant et des moyens pour traiter les suites S de signaux ainsi enregistrées de façon à faire apparaître la distribution électrique dans l'isolant.

Dans des modes de réalisation préférés, on a recours en outre à l'une et/ou à l'autre des dispositions suivantes :
- la différence de potentiel ou tension variable est une tension sinusoïdale dont l'amplitude est croissante au cours du temps, de façon de préférence réglable,
- la fréquence de la tension sinusoïdale selon l'alinéa précédent est égale à 50 Hz ou 60 Hz,
- entre les électrodes et les moyens d'enregistrement sont prévus un filtre passe-haut traversé par les composantes à fréquence fᵣ et basse tension de la tension recueillie aux bornes des électrodes et un amplificateur de la tension délivrée par ce filtre passe-haut,
- entre l'amplificateur selon l'alinéa précédent et les moyens d'enregistrement est prévue une porte dont l'ouverture chronique, de durée inférieure à la durée de traversée de l'isolant par chaque déformation, est déclenchée, lors de chacune desdites traversées, par un signal à retard réglable synchronisé avec le générateur de fonctions,
- le dispositif créateur de déformations est un laser propre à émettre des impulsions de quelques ns à une fréquence de l'ordre de 500 à 5000 hz.

L'invention comprend, mises à part ces dispositions principales, certaines autres dispositions qui s'utilisent de préférence en même temps et dont il sera plus explicitement question ci-après.

Dans ce qui suit, l'on va décrire quelques modes de réalisation préférés de l'invention en se référant au dessin ci-annexé d'une manière bien entendu non limitative.

La figure 1, de ce dessin, est un schéma d'un dispositif d'étude d'isolant électrique établi selon l'invention.

La figure 2 montre la forme d'une tension électrique alternative avantageusement appliquée aux bornes des électrodes encadrant ledit isolant.

La figure 3 montre une portion de ladite tension à plus grande échelle.

La figure 4 montre la forme des impulsions propres à déclencher le dispositif créateur de déformations compris par le dispositif d'étude ci-dessus.

La figure 5 montre la forme des courbes susceptibles d'être visualisées par les moyens d'exploitation constitutifs du dispositif d'étude ci-dessus.

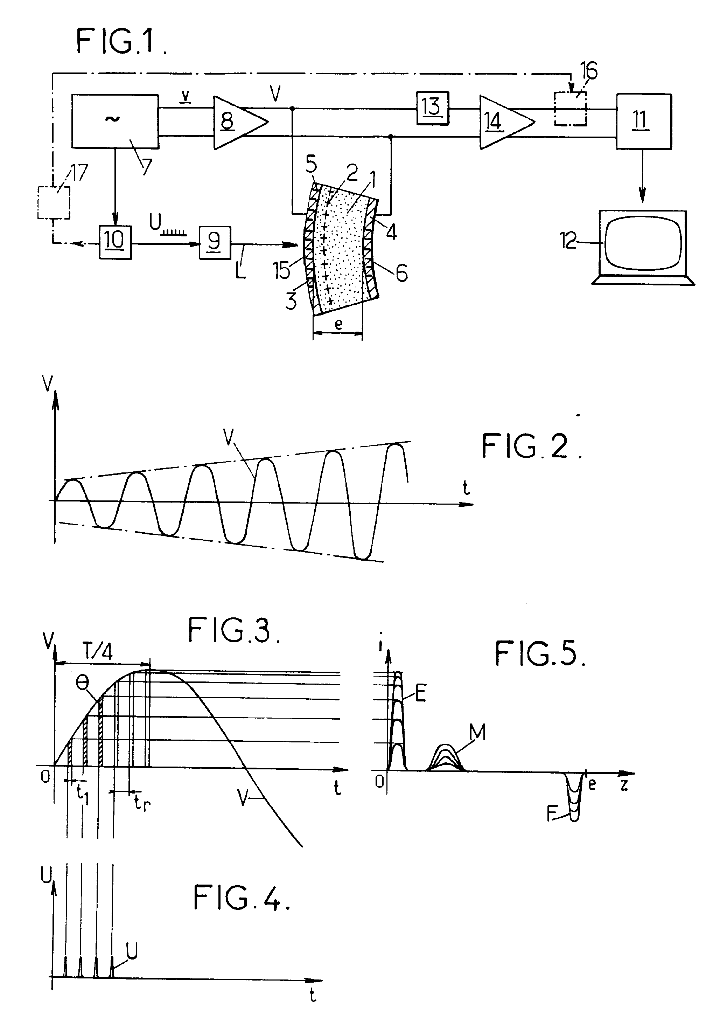

On se propose d'étudier la répartition de paramètres électriques (charges, polarisations, champs...) à l'intérieur d'un isolant 1 (figure 1) qui est ici supposé constituer une gaine isolante pour un câble transporteur de courant électrique alternatif.

A titre purement illustratif, on suppose ici que les paramètres ci-dessus sont des charges électriques 2 représentées par le signe +.

De part et d'autre de l'isolant 1 sont placées deux électrodes 3 et 4 qui portent des charges électriques 5,6 induites par les charges 2 et ici représentées à titre purement illustratif par le signe -.

Ces électrodes 3,4 forment les armatures d'un condensateur.

Le dispositif d'étude de la répartition électrique des charges 2 comprend :
- un générateur de fonctions 7 propre à engendrer une tension électrique v variable dans le temps selon une forme, une fréquence et une amplitude réglables,
- un amplificateur 8 de cette tension v propre à la transformer en une tension V de relativement grande amplitude, laquelle tension V est appliquée aux bornes des électrodes 3 et 4,
- un dispositif 9 propre à créer chroniquement des déformations brusques dans l'isolant 1,
- un dispositif de retard 10 synchronisé avec un passage à zéro de la tension v engendrée par le générateur 7 et propre à élaborer une suite d'impulsions U de déclenchement du dispositif 9 se succédant à une fréquence de récurrence fᵣ,
- et un ensemble d'enregistrement et de calcul 11 connecté aux bornes des deux électrodes 3 et 4 -ou d'un organe équivalent- de façon à détecter et recueillir des suites S de signaux élaborés entre ces bornes lors des propagations successives des déformations ci-dessus dans l'isolant 1, puis à traiter ces suites en vue de leur visualisation ultérieure, et des moyens de visualisation ou analogues 12, tels qu'un oscilloscope, permettant de faire apparaître, à partir des données ainsi enregistrées et traitées, la répartition des charges 2 dans l'isolant 1.

La fréquence fᵣ est de l'ordre de 1000 Hz, étant plus généralement comprise entre 500 et 50000 Hz : ces valeurs correspondent à celles données ci-dessus pour la période de récurrence correspondante tᵣ, indiquée comme étant de l'ordre de 1 ms, et plus généralement comprise entre 20 »s et 2 ms.

Pour faciliter la détection des signaux utiles par l'ensemble 11, on interpose entre les électrodes 3,4 et cet ensemble :
- un filtre passe-haut 13 propre à ne laisser passer que les composantes à relativement haute fréquence fᵣ et à relativement basse tension de la tension électrique détectée aux bornes desdites électrodes,
- et un amplificateur 14 propre à amplifier les signaux ayant traversé le filtre 13.

Pour ce qui est de la tension variable v délivrée par le générateur 7, elle peut affecter toute forme désirable.

Selon un mode de réalisation avantageux, il s'agit d'une tension alternative et plus précisément sinusoïdale dont la fréquence f est de préférence égale à 50 Hz ou voisine d'une telle valeur, par exemple égale à 60 Hz.

En outre, on prévoit avantageusement des moyens pour régler à volonté l'amplitude de cette tension alternative v, de façon notamment à la faire croître progressivement.

Dans le cas préféré indiqué de la tension sinusoïdale, l'amplificateur 8 est un transformateur.

On voit sur la figure 2 la forme de la tension amplifiée résultante V, de fréquence f, dont la période T est de 20 ms dans le cas préféré où la fréquence f est égale à 50 Hz.

Le rapport de l'amplificateur est notamment de l'ordre de 1000 à 10000 et l'amplitude de la tension V est de l'ordre de 20 à 60 kV, cette valeur pouvant même atteindre ou dépasser 200 kV.

La figure 3 est un agrandissement de l'une des demi-alternances de la tension V.

Pour ce qui est du dispositif 9 créateur de déformations, on peut le constituer de l'une des manières exposées ci-dessus, par tout organe désirable susceptible d'engendrer dans l'isolant une déformation ou pression brusque, c'est-à-dire de durée d'établissement t₀ relativement petite (par exemple de l'ordre de quelques ns), en réponse à l'application d'une impulsion de tension électrique U de déclenchement et de synchronisation.

Un tel organe est par exemple du type piézoélectrique propre à transformer une telle impulsion de tension en une impulsion de pression, laquelle est appliquée sur l'une des électrodes 3 par mise en contact dudit organe avec celle-ci.

Il peut encore être constitué par un canon à électrons propre à appliquer une impulsion calorifique instantanée sur ladite électrode 3.

Ou encore ledit organe est de nature à appliquer entre les électrodes indépendamment de la tension V (sauf pour ce qui est de la synchronisation), une impulsion de tension électrique, par exemple de l'ordre de 5 kV, à temps de montée très bref.

Dans les modes de réalisation préférés, on constitue le dispositif 9 en question par un laser propre à envoyer des impulsions lumineuses sur l'électrode 3 et plus précisément sur une plage 15 faisant partie de cette électrode ou contiguë à celle-ci, aménagée en cible, plage par exemple constituée par un revêtement local de graphite, un matériau adaptateur d'impédance du genre des gels ou graisses étant avantageusement interposé entre ladite plage 15 et l'électrode 3 si ces deux éléments sont distincts.

Les impulsions lumineuses provenant du laser 9, schématisées par la flèche L sur la figure 1, sont déclenchées par des impulsions U émises à la fréquence fᵣ à partir du dispositif de retard 10.

Le laser 9 est de préférence d'un type solide, propre à émettre à une fréquence comprise entre 500 et 5000 Hz des impulsions lumineuses L de quelques nanosecondes.

L'origine du train d'impulsions U est synchronisée avec un passage à zéro de la tension V, ainsi qu'il a été illustré sur la figure 4, laquelle fait apparaître lesdites impulsions de tension U se succédant dans le temps à la fréquence de récurrence fᵣ, c'est-à-dire étant espacées dans le temps les unes des autres de périodes tᵣ.

Comme visible sur la figure 3, il correspond à chacune de ces impulsions U une tranche de mesure ϑ (hachurée sur le dessin) de durée t₁ très petite au cours de laquelle la tension V qui est appliquée aux bornes des deux électrodes 3 et 4 peut être considérée comme ayant une valeur constante en première approximation : cette durée t₁ très petite, par exemple de l'ordre de la microseconde, est celle qui correspond à la traversée de l'épaisseur e totale de l'isolant 1 par chacune des déformations ci-dessus ; elle est en général de l'ordre de 1000 fois plus petite que la période de récurrence tᵣ.

La mesure effectuée dans chaque courte tranche ϑ peut être considérée comme comparable à celle qui était effectuée selon le procédé connu ci-dessus évoqué, la différence étant ici que ladite mesure n'est pas unique, mais suivie par une pluralité d'autres mesures du même genre, correspondant respectivement à des polarisations électriques différentes de l'isolant 1.

Au cours de seulement un quart de la période T de la tension V, on procède à un certain nombre de mesures successives s'étendant chacune sur la durée t₁ et séparées les unes des autres de la durée de récurrence tᵣ, la valeur de la polarisation électrique de l'isolant croissant progressivement, pour l'exemple de la figure 3, de 0 à l'amplitude maximum de la tension sinusoïdale V.

Dans le cas le plus général, ce sont toutes les suites S des signaux élaborés successivement aux bornes des électrodes 3 et 4 qui sont enregistrées dans l'ensemble 11.

Pour faire apparaître ensuite la répartition des charges 2 dans ledit isolant 1, on peut visualiser successivement les différentes suites S correspondant à une durée déterminée s'étendant notamment sur le quart de période T/4 considéré ci-dessus.

Selon une variante intéressante, on n'enregistre pas la totalité des suites de signaux apparaissant aux bornes des électrodes 3 et 4, mais seulement les portions, de ces suites, qui correspondent à des zones singulières de la masse de l'isolant étudié, zones telles que ses interfaces d'entrée et de sortie, c'est-à-dire ses portions adjacentes aux deux électrodes 3 et 4.

Sur le graphique de la figure 5, on a fait apparaître une courbe représentant les signaux électriques détectés aux bornes des électrodes 3 et 4 en portant en ordonnées, l'amplitude du courant électrique correspondant i et, en abscisses, le temps t ou, ce qui revient au même, la distance z entre le point, intérieur à l'isolant 1, correspondant à la mesure effectuée et l'entrée de cet isolant pour la déformation concernée : cette courbe présente un premier pic E de relativement grande amplitude au voisinage de l'entrée et un second pic F de sens contraire et d'amplitude plus petite au voisinage de la sortie.

La portion, des signaux électriques élaborés par l'installation ci-dessus, qui est enregistrée, peut alors être limitée à la zone correspondant à l'un des deux pics E et F.

Il suffit à cet effet d'interposer entre l'amplificateur 14 et l'ensemble 11 une porte appropriée 16 (figure 1) dont l'ouverture momentanée n'est commandée que pour une portion t₂, bien déterminée dans le temps, de chaque durée de mesure t₁, les signaux de commande de cette ouverture étant alors élaborés par un circuit 17 lui-même synchronisé avec précision à partir du dispositif à retard 10, par rapport à un passage à zéro de la tension V.

Dans ces conditions, les suites de signaux enregistrées permettent de reproduire successivement, par exemple, les pics de courant d'entrée E (figure 5) correspondant aux tranches successives de mesure ϑ.

Les amplitudes de ces pics successifs sont proportionnelles aux champs électriques instantanés qui règnent dans l'isolant 1 au voisinage de l'électrode d'entrée 3, ce qui permet de connaître l'évolution réelle dudit champ électrique à l'endroit indiqué au cours de l'application de la tension alternative V aux bornes des électrodes 3 et 4.

L'ouverture de la porte 16 peut être également commandée de manière à faire apparaître l'évolution de l'amplitude du champ électrique en n'importe quelle zone de l'isolant 1, notamment en un point où est localisée une charge électrique 2, laquelle se manifeste par un léger pic M de courant i (figure 5) : ce point peut par exemple correspondre à une interface, de position connue, entre deux couches isolantes de caractéristiques différentes, ou son emplacement peut être identifié par une détection préalable conduite de manière à s'étendre à la totalité de l'épaisseur de l'isolant à étudier.

Les résultats ci-dessus, ou plus généralement ceux qui peuvent être tirés des différentes suites de signaux enregistrées dans l'ensemble 11, permettent de suivre l'évolution de certains phénomènes électriques qui se produisent dans un isolant soumis à une polarisation électrique alternative et de connaître exactement le processus de cette évolution.

Dans le mode de réalisation préféré décrit ci-dessus pour lequel il est possible de faire croître progressivement, de façon réglable, l'amplitude de la différence de potentiel électrique V appliquée aux bornes des électrodes encadrant l'isolant étudié (voir figure 2), la connaissance de l'évolution réelle des phénomènes électriques présents dans l'isolant peut se révéler extrêmement précieuse pour combattre l'apparition de désordres ou tout au moins empêcher que ceux-ci aboutissent au claquage et à la destruction de l'isolant considéré.

Cette connaissance peut également permettre d'optimiser les processus de polarisation des matériaux piézoélectriques ou pyroélectriques dans lesquels on crée une telle polarisation par application d'un champ électrique continu.

En suite de quoi, et quel que soit le mode de réalisation adopté, on obtient finalement un procédé et un dispositif permettant d'étudier de façon non destructive la répartition de charges ou autres paramètres électriques au sein d'un isolant au cours même de l'application sur celui-ci d'une différence de potentiel d'amplitude variable, et notamment alternative.

Comme il va de soi, et comme il résulte d'ailleurs déjà de ce qui précède, l'invention ne se limite nullement à ceux de ses modes d'application et de réalisation qui ont été plus spécialement envisagés ; elle en embrasse, au contraire, toutes les variantes, notamment:
- celles où, pour éviter les inconvénients sur les mesures des réflexions multiples des ondes de pression à la sortie d'au moins la seconde électrode (électrode atteinte en second par lesdites ondes), celle-ci serait recouverte par un matelas absorbant ou dissipatif présentant la même impédance acoustique que l'isolant et que l'électrode et une épaisseur suffisante pour que les ondes de pression considérées y soient suffisamment atténuées, ladite épaisseur étant généralement de l'ordre de quelques mm à quelques cm,
- et celles où des moyens seraient prévus pour compenser les éventuelles fluctuations ou dérives affectant la création des déformations brusques successives dans l'isolant, moyens propres à mesurer un paramètre lié à chaque déformation (intensité lumineuse si on utilise un laser, tension électrique, etc.), à élaborer un signal de correction lié aux variations de ce paramètre et à exploiter les signaux de correction ainsi élaborés aux fins de compensation désirées.

## Revendications

1. Procédé pour étudier la distribution de charges électriques dans un isolant électrique, faisant appel à la suite d'opérations suivantes : disposition de la masse isolante à étudier (1) entre deux électrodes (3,4), application d'une différence de potentiel élevée aux bornes de ces électrodes, création dans l'isolant d'une déformation brusque se propageant à l'intérieur de cet isolant, amplification des signaux électriques engendrés par cette propagation, enregistrement de la suite S des signaux ainsi amplifiés et traitement des signaux enregistrés de façon à faire apparaître la distribution électrique dans l'isolant, caractérisé en ce que l'on donne à la différence de potentiel (V) une valeur variable, en ce que l'on renouvelle de façon récurrente la création de la déformation à une fréquence fᵣ comprise entre 500 et 50000 Hz, en ce que l'on enregistre successivement de multiples suites S de signaux correspondant respectivement aux propagations successives des déformations récurrentes dans l'isolant et en ce que l'on traite les suites S ainsi enregistrées de façon à faire apparaître la distribution électrique dans l'isolant.

2. Dispositif pour étudier la distribution de charges électriques dans un isolant électrique, caractérisé en ce qu'il comprend un générateur de fonctions (7) propre à engendrer une tension électrique (v) variable dans le temps, un amplificateur (8) propre à amplifier la tension issue du générateur de fonctions, la tension ainsi amplifiée (V) étant appliquée aux bornes d'électrodes (3,4) encadrant l'isolant, un dispositif (9) propre à créer des déformations brusques se propageant à l'intérieur de l'isolant, un dispositif de retardement (10) synchronisé avec le générateur de fonctions propre à déclencher le dispositif créateur de déformations d'une façon récurrente, à une fréquence fᵣ comprise entre 500 et 50000 Hz, des moyens (11) pour enregistrer successivement de multiples suites S de signaux liés aux signaux électriques engendrés par les propagations successives des déformations récurrentes dans l'isolant et des moyens (12) pour traiter les suites S de signaux ainsi enregistrées de façon à faire apparaître la distribution électrique dans l'isolant.

3. Dispositif d'étude selon la revendication 2, caractérisé en ce que la différence de potentiel ou tension variable (V) est une tension sinusoïdale dont l'amplitude est croissante au cours du temps, de façon de préférence réglable.

4. Dispositif d'étude selon la revendication 3, caractérisé en ce que la fréquence de la tension sinusoïdale est égale à 50 Hz ou 60 Hz.

5. Dispositif d'étude selon l'une quelconque des revendications 2 à 4, caractérisé en ce que, entre les électrodes (3,4) et les moyens d'enregistrement (11), sont prévus un filtre passe-haut (13) traversé par les composantes à fréquence fᵣ et basse tension de la tension recueillie aux bornes des électrodes et un amplificateur (14) de la tension délivrée par ce filtre passe-haut.

6. Dispositif d'étude selon la revendication 5, caractérisé en ce que, entre l'amplificateur (14) et les moyens d'enregistrement (11), est prévue une porte (16) dont l'ouverture chronique, de durée inférieure à la durée de traversée de l'isolant par chaque déformation, est déclenchée, lors de chacune dedites traversées, par un signal à retard réglable synchronisé avec le générateur de fonctions (7).

7. Dispositif d'étude selon l'une quelconque des revendications 2 à 6, caractérisé en ce que le dispositif créateur de déformations (9) est un laser propre à émettre des impulsions de quelques ns à une fréquence de l'ordre de 500 à 5000 Hz.

8. Dispositif d'étude selon l'une quelconque des revendications 2 à 7, caractérisé en ce qu'au moins l'électrode (4) atteinte en second lieu par chaque déformation est revêtue sur sa face la plus éloignée de l'isolant par un épais coussin propre à absorber l'onde de cette déformation.

9. Dispositif d'étude selon l'une quelconque des revendications 2 à 8, caractérisé en ce qu'il comprend en outre des moyens pour compenser les éventuelles fluctuations ou dérives affectant la création des déformations brusques successives dans l'isolant, moyens propres à mesurer un paramètre lié à chaque déformation, à élaborer un signal de correction lié aux variations de ce paramètre et à exploiter les signaux de correction ainsi élaborés aux fins de compensation désirées.

## Claims

1. A method of investigating the distribution of electric charge in an electrical insulator, the method making use of the following sequence of operations: placing a mass of the insulator (1) to be investigated between two electrodes (3, 4); applying a high potential difference to the terminals of said electrodes; creating a sudden deformation in the insulator, which deformation propagates within said insulator; amplifying the electrical signals generated by said propagation; recording the sequence S of signals as amplified in this way; and processing the recorded signals so as to cause the desired electrical distribution in the insulator to appear; the method being characterized in that the potential difference V is given a value that is variable, in that the creation of the deformation is renewed at a recurrence frequency fᵣ lying in the range 500 Hz to 50000 Hz, in that successive multiple sequences S of signals corresponding to respective successive propagations of the recurrent deformations within the insulator are recorded, and in that the sequences S recorded in this way are processed so as to show up the electrical distribution within the insulator.

2. Investigation apparatus for investigating the distribution of electric charge within an electrical insulator, the apparatus being characterized in that it comprises: a function generator (7) suitable for generating a time-varying electrical voltage v, an amplifier (8) suitable for amplifying the voltage from the function generator, the voltage V amplified in this way being applied to the terminals of electrodes (3, 4) on either side of the insulator, apparatus (9) suitable for creating sudden deformations that propagate within the insulator, a delay circuit (10) synchronized with the function generator and suitable for triggering the apparatus for creating deformations at a recurrence frequency fᵣ lying in the range 500 Hz to 50000 Hz, means (11) for successively recording multiple sequences S of signals relating to the electrical signals generated by the successive propagations of the recurrent deformations within the insulator, and means (12) for processing the sequences S of signals recorded in this way so as to cause the electrical distribution within the insulator to appear.

3. Investigation apparatus according to claim 2, characterized in that the variable voltage or potential difference V is a sinewave voltage whose amplitude increases over time, preferably in adjustable manner.

4. Investigation apparatus according to claim 3, characterized in that the frequency of the sinewave voltage is equal to 50 Hz or to 60 Hz.

5. Investigation apparatus according to anyone of claims 2 to 4, characterized in that both a highpass filter (13) for passing components at the frequency fᵣ and at low voltage in the voltage picked up at the terminals of the electrodes, and an amplifier (14) for amplifying the voltage delivered by said highpass filter are provided between the electrodes (3, 4) and the recording means (11).

6. Investigation apparatus according to claim 5, characterized in that a gate (16) is provided between the amplifier (14) and the recording means (11), the opening in time of the gate being of a duration less than the time taken by each deformation to cross through the insulator, said opening being triggered on each occasion that a deformation is crossing through the insulator by a signal of adjustable delay synchronized on the function generator (7).

7. Investigation apparatus according to anyone of claims 2 to 6, characterized in that the deformation-creating apparatus (9) is a laser suitable for emitting pulses of a few ns duration at a frequency of the order of 500 Hz to 5000 Hz.

8. Investigation apparatus according to anyone of claims 2 to 7, characterized in that at least the electrode (4) that is reached second by each deformation is coated on its face furthest from the insulator by a thick cushion suitable for absorbing the wave of said deformation.

9. Investigation apparatus according to anyone of claims 2 to 8, characterized in that it further includes means for compensating possible fluctuations affecting the creation of the successive sudden deformations within the insulator, said means being suitable for measuring a parameter relating to each deformation, for generating a correction signal relating to variations in said parameter, and for making use of the correction signals generated in this way for the purposes of achieving the desired compensation.

## Patentansprüche

1. Verfahren zur Untersuchung der Verteilung elektrischer Ladungen in einem elektrischen Isolator, umfassend die folgende Abfolge von Vorgängen: Anordnen der zu untersuchenden Isolatormasse (1) zwischen zwei Elektroden (3, 4), Anlegen einer erhöhten Potentialdifferenz an die Anschlüsse dieser Elektroden, Erzeugen einer plötzlichen, sich im Inneren des Isolators ausbreitenden Verformung in diesem Isolator, Verstärken der von dieser Ausbreitung erzeugten elektrischen Signale, Aufzeichnen der Abfolge S der so verstärkten Signale und Bearbeiten der aufgezeichneten Signale in der Weise, daß die elektrische Verteilung in dem Isolator aufscheint, **dadurch gekennzeichnet,** daß man der Potentialdifferenz (V) einen veränderlichen Wert gibt, daß man die Erzeugung der Verformung mit einer zwischen 500 und 50000 Hz enthaltenen Frequenz fᵣ wiederholt erneuert, daß man aufeinanderfolgend mehrere Abfolgen S von Signalen aufzeichnet, welche jeweils aufeinanderfolgenden Ausbreitungen der wiederholten Verformungen in dem Isolator entsprechen, und daß man die so aufgezeichneten Abfolgen S derart verarbeitet, daß die elektrische Verteilung in dem Isolator aufscheint.

2. Vorrichtung zur Untersuchung der Verteilung von elektrischen Ladungen in einem elektrischen Isolator, **da****durch gekennzeichnet,** daß sie umfaßt: einen Funktionsgenerator (7), der geeignet ist, eine zeitlich veränderliche elektrische Spannung (v) zu erzeugen, einen Verstärker (8), der geeignet ist, die Ausgangsspannung des Funktionsgenerators zu verstärken, wobei die so verstärkte Spannung (V) an die Anschlüsse der den Isolator zwischen sich aufnehmenden Elektroden (3, 4) angelegt ist, eine Vorrichtung (9), die geeignet ist, plötzliche sich im Inneren des Isolators ausbreitende Verformungen zu erzeugen, eine Verzögerungsvorrichtung (10), die zu dem Funktionsgenerator synchronisiert ist und geeignet ist, die Vorrichtung zur Erzeugung von Verformungen wiederholt mit einer zwischen 500 und 50000 Hz enthaltenen Frequenz fᵣ auszulösen, Mittel (11) zum aufeinanderfolgenden Aufzeichnen mehrerer Abfolgen S von Signalen, die mit den von den aufeinanderfolgenden Ausbreitungen der wiederholten Verformungen in dem Isolator erzeugten elektrischen Signale verbunden sind, und Mittel (12) zur Bearbeitung der so aufgezeichneten Signalabfolgen S, um die elektrische Verteilung in dem Isolator aufzuzeigen.

3. Untersuchungsvorrichtung nach Anspruch 2, **dadurch** **gekennzeichnet,** daß die veränderliche Potentialdifferenz bzw. die veränderliche Spannungsdifferenz (V) eine sinusförmige Spannung ist, deren Amplitude im Verlauf der Zeit, vorzugsweise steuerbar, anwächst.

4. Untersuchungsvorrichtung nach Anspruch 3, **dadurch** **gekennzeichnet**, daß die Frequenz der sinusförmigen Spannung 50 Hz oder 60 Hz beträgt.

5. Untersuchungsvorrichtung nach einem der Ansprüche 2 bis 4, **dadurch gekennzeichnet**, daß zwischen den Elektroden (3, 4) und den Aufzeichnungsmitteln (11) ein Hochpaßfilter (13) vorgesehen ist, welches die Komponenten mit Frequenz fᵣ und niedriger Spannung der an den Anschlüssen der Elektroden aufgenommenen Spannung passieren läßt, sowie ein Verstärker (14) für die von diesem Hochpaßfilter gelieferte Spannung vorgesehen ist.

6. Untersuchungsvorrichtung nach Anspruch 5, **dadurch** **gekennzeichnet**, daß zwischen dem Verstärker (14) und den Aufzeichnungsmitteln (11) ein Gatter (16) vorgesehen ist, wobei die regelmäßige Öffnung des Gatters (16) von einem steuerbaren, zu dem Funktionsgenerator (7) synchronisierten Verzögerungssignal mit einer Zeitdauer, die kleiner ist als die zum Durchqueren des Isolators von jeder Verformung erforderliche Zeitdauer, bei jeder dieser Durchquerungen ausgelöst wird.

7. Untersuchungsvorrichtung nach einem der Ansprüche 2 bis 6, **dadurch gekennzeichnet**, daß die Vorrichtung (9) zum Erzeugen von Verformungen ein Laser ist, der geeignet ist, Impulse von einigen ns mit einer Frequenz in der Größenordnung von 500 bis 5000 Hz auszusenden.

8. Untersuchungsvorrichtung nach einem der Ansprüche 2 bis 7, **dadurch gekennzeichnet**, daß wenigstens die als zweite von jeder Verformung erreichte Elektrode (4) an ihrer von dem Isolator entferntesten Fläche von einem dicken Puffer bedeckt ist, welcher geeignet ist, die Welle dieser Verformung zu absorbieren.

9. Untersuchungsvorrichtung nach einem der Ansprüche 2 bis 8, **dadurch gekennzeichnet**, daß sie ferner Mittel umfaßt zum Kompensieren der eventuellen Fluktuationen oder Abweichungen, welche die Erzeugung von plötzlichen aufeinanderfolgenden Verformungen in dem Isolator beeinflussen, Mittel, die geeignet sind, einen mit jeder Verformung verbundenen Parameter zu messen, ein mit Veränderungen dieses Parameters verbundenes Korrektursignal zu erzeugen und die so erzeugten Korrektursignale zum Zwecke der gewünschten Kompensationen auszuwerten.
